# EUROPEAN PATENT APPLICATION

(11) **EP 1 126 598 A2**
(43) Date of publication of application: **22.08.2001**
(21) Application number: 00311222.4
(22) Date of filing: 15.12.2000
(51) Int. Cl.: H03G 3/30

(54) **Oscillator output amplifier**

(30) Priority: 24.01.2000 JP 2000017947
(71) Applicant: ALPS ELECTRIC CO., LTD., Ota-ku Tokyo 145 (JP)
(72) Inventor: Ikarashi, Yasuhiro, Otsuka-cho, Ota-ku, Tokyo 145 (JP)
(74) Representative: Kensett, John Hinton

(57) **Abstract**

An oscillating device of the invention has an oscillating unit (1) for outputting an oscillating signal and an amplifying unit (2) for amplifying the oscillating signal, and gain of the amplifying unit is switched in two levels.

## Description

### BACKGROUND OF THE INVENTION

### Field of the Invention

The present invention relates to an oscillating device which switches an oscillation signal outputted from an oscillating unit in two levels by an amplifying unit and outputs a resultant signal.

### Description of the Related Art

Conventional oscillating devices include an oscillating device constructed only by a voltage controlled oscillator and an oscillating device constructed by adding an amplifying unit for amplifying an oscillation signal outputted from a voltage controlled oscillator. Each of such oscillating devices is used, for example, as a carrier oscillator, a modulator, a local oscillator, and the like in a transmitting/receiving circuit in a portable telephone or the like.

For example, in the case where the oscillating device is used as a modulator, an oscillation signal as a carrier wave is modulated by a modulation signal, the output (modulated signal) is amplified to a predetermined level by a power amplifier (not shown) and, after that, the resultant signal is transmitted as a transmission signal from an antenna (not shown).

The transmission power of the transmission signal transmitted from the antenna is determined by the performances such as the gain and the maximum output power of the power amplifier. Usually, the gain of the power amplifier has, however, variations of about ± 3 dB (range of 6 dB). Consequently, for example, an oscillating device of a high oscillation signal level is used for a power amplifier of low gain so that the transmission power becomes a predetermined value.

Recently, a portable telephone which can be commonly used by two different systems has been practically used. Since the transmission power of such a portable telephone is specified according to each of the systems, two power amplifiers of different gains are used and switched.

As described above, in the case of using the conventional oscillating device for a portable telephone, an oscillating device having an optimum oscillation signal level in correspondence with variations in gain of the power amplifier is combined or two power amplifiers are used. Consequently, the number of models of oscillating devices increases and manufacturing management is complicated. It is inevitable that the shape of the portable telephone is enlarged and, further, the price of the produce cannot be reduced.

### SUMMARY OF THE INVENTION

It is therefore an object that an oscillating device of the invention can be variously used with the small number of models by constructing the oscillating device so that an oscillation signal level can be changed.

As means for solving the problems, an oscillating device of the invention has an oscillating unit for outputting an oscillation signal and an amplifying unit for amplifying the oscillation signal, and gain of the amplifying unit is switched in two levels.

Preferably, the amplifying unit has an amplifying transistor for amplifying the oscillation signal and a bias voltage supplying circuit for supplying a bias voltage to the base of the amplifying transistor, the oscillation signal is supplied to the base of the amplifying transistor, a first bias voltage or a second bias voltage is supplied to the base of the amplifying transistor by the bias voltage supplying circuit, and the value of the first bias voltage and that of the second bias voltage are set to be different from each other.

Preferably, the bias voltage supplying circuit has: first switching means and a first resistor which are connected to each other in series and are connected between a power source and the base of the amplifying transistor; second switching means and a second resistor which are connected to each other in series and are connected between the power source and the base of the amplifying transistor; and a third resistor connected between the base of the amplifying transistor and the ground, a resistance value of the first resistor and a resistance value of the second resistor are set to be different from each other, and either the first switching means is turned on and the second switching means is turned off, or the first switching means is turned off and the second switching means is turned on.

Optionally, an NPN transistor is used as the first switching means, a PNP transistor is used as the second switching means, the collector of the NPN transistor is connected to the power source and the emitter of the NPN transistor is connected to the base of the amplifying transistor via the first resistor, the emitter of the PNP transistor is connected to the power source and the collector of the PNP transistor is connected to the base of the amplifying transistor via the second resistor, and either a first voltage to turn on the NPN transistor and turn off the PNP transistor or a second voltage to turn off the NPN transistor and turn on the PNP transistor is applied to both the base of the NPN transistor and the base of the PNP transistor.

Optionally , the bias voltage supplying circuit has: first switching means and a fourth resistor which are connected to each other in series and are connected between the base of the amplifying transistor and the ground; second switching means and a fifth resistor which are connected to each other in series and are connected between the base of the amplifying transistor and the ground; and a sixth resistor connected between the power source and the base of the amplifying transistor, a resistance value of the fourth resistor and a resistance value of the fifth resistor are set to be different from each other, and either the first switching means is turned on and the second switching means is turned off, or the first switching means is turned off and the second switching means is turned on.

Optionally,an NPN transistor is used as the first switching means, a PNP transistor is used as the second switching means, the emitter of the NPN transistor is connected to the ground and the collector of the NPN transistor is connected to the base of the amplifying transistor via the fourth resistor, the collector of the PNP transistor is connected to the ground and the emitter of the PNP transistor is connected to the base of the amplifying transistor via the fifth resistor, and either a first voltage to turn on the NPN transistor and turn off the PNP transistor or a second voltage to turn off the NPN transistor and turn on the PNP transistor is applied to both the base of the NPN transistor and the base of the PNP transistor.

In an embodiment of the invention, the gain of the amplifying unit may be changed by at least 3 dB to 4 dB.

### BRIEF DESCRIPTION OF DRAWINGS

Fig. 1 is a circuit diagram showing the configuration of an oscillating device of the invention.

Fig. 2 is a circuit diagram showing a first specific configuration of the oscillating device of the invention.

Fig. 3 is a circuit diagram showing a second specific configuration of the oscillating device of the invention.

### DETAILED DESCRIPTION OF THE PREFERRED EMBODIMENTS

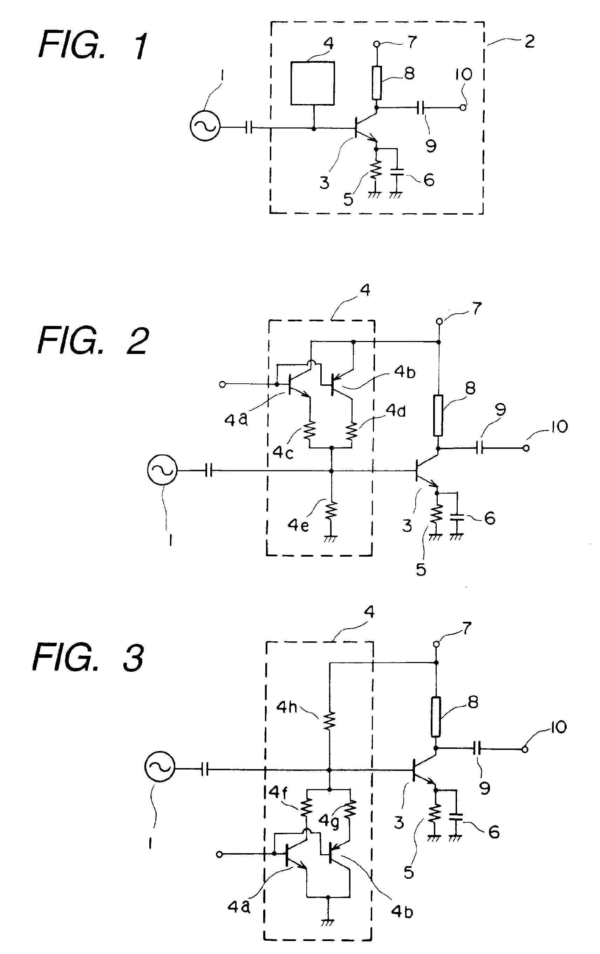

An oscillating device of the invention will be described hereinbelow with reference to the drawings. Fig. 1 is a circuit diagram showing the configuration of an oscillating device of the invention. Fig. 2 is a circuit diagram showing a first specific configuration of the oscillating device of the invention. Fig. 3 is a circuit diagram showing a second specific configuration of the oscillating device of the invention.

The oscillating device of the invention has an oscillating unit 1 and an amplifying unit 2 as shown in Fig. 1, and the oscillating unit 1 takes the form of a voltage controlled oscillator or the like. The amplifying unit 2 has an amplifying transistor 3 and a bias voltage supplying circuit 4 for supplying a bias voltage to the base of the amplifying transistor 3. The emitter of the amplifying transistor 3 is connected to the ground via an emitter bias resistor 5 and a bypass capacitor 6. A power supply voltage is supplied to the collector of the amplifying transistor 3 from a power supply terminal 7 via a choke inductor 8 or the like. An oscillation signal outputted from the oscillating unit 1 is supplied to the base of the amplifying transistor. An amplified oscillation signal appears at the collector and is taken at an output terminal 10 via a coupling capacitor 9.

The bias voltage supplied from the bias voltage supplying circuit 4 to the base of the amplifying transistor 3 is switched in two levels. When the bias voltage of the base is switched, a collector current of the amplifying transistor 3 is changed in correspondence with it, thereby changing the gain by 3dB to 4dB. Therefore, the level of the oscillation signal outputted from the oscillating device changes by 3dB to 4dB.

A first specific configuration of the bias voltage supplying circuit 4 is shown in Fig. 2. The bias voltage supplying circuit 4 has: an NPN transistor (first switching means) 4a whose collector is connected to the power supply terminal 7; a PNP transistor 4b (second switching means) whose emitter is connected to the power supply terminal 7; a first resistor 4c connected between the emitter of the NPN transistor 4a and the base of the amplifying transistor 3; a second resistor 4d connected between the collector of the PNP transistor 4b and the base of the amplifying transistor 3; and a third resistor 4e connected between the base of the amplifying transistor 3 and the ground.

Therefore, the NPN transistor 4a and the first resistor 4c are connected to each other in series and the PNP transistor 4b and the second resistor 4d are connected to each other in series.

The base of the NPN transistor 4a and the base of the PNP transistor 4b are connected to each other and also to a gain control terminal 11. A high-level control voltage (first voltage) or a low-level control voltage (second voltage) is applied to the gain control terminal 11. The first voltage is used to turn on the NPN transistor 4a and turn off the PNP transistor 4b and is, for example, equal to the power supply voltage. The second voltage is used to turn off the NPN transistor 4a and turn on the PNP transistor 4b and is, for example, equal to zero volt.

Further, the resistance value of the first resistor 4c and that of the second resistor 4d are set to be different from each other. For example, the resistance value of the first resistor 4c is set to be smaller than that of the second resistor 4d.

As a result, when the first voltage is applied to the gain control terminal 11, only the NPN transistor 4a is turned on, and the first bias voltage is applied to the base of the amplifying transistor 3 by the first resistor 4c and the third resistor 4e.

On the other hand, when the second voltage is applied to the gain control terminal 11, only the PNP transistor 4b is turned on and a second bias voltage is applied to the base of the amplifying transistor 3 by the second resistor 4c and the third resistor 4e.

Since the first bias voltage is higher than the second bias voltage, the collector current of the amplifying transistor 3 becomes larger in the case where the first bias voltage is applied than in the case where the second bias voltage is applied, and the gain is also increased.

The level of the oscillation signal outputted from the amplifying transistor 3 can be therefore changed by the control voltage applied to the gain control terminal 11.

Fig. 3 shows a second specific configuration of the bias voltage supplying circuit 4. The bias voltage supplying circuit 4 has: the NPN transistor 4a (first switching means) whose emitter is connected to the ground; the PNP transistor 4b (second switching means) whose collector is connected to the ground; a fourth resistor 4f connected between the base of the amplifying transistor 3 and the collector of the NPN transistor 4a; a fifth resistor 4g connected between the base of the amplifying transistor 3 and the emitter of the PNP transistor 4b; and a sixth resistor 4h connected between the power supply terminal 7 and the base of the amplifying transistor 3.

Therefore, the NPN transistor 4a and the fourth resistor 4f are connected to each other in series and the PNP transistor 4b and the fifth resistor 4g are connected to each other in series.

The base of the NPN transistor 4a and the base of the PNP transistor 4b are connected to each other and also to the gain control terminal 11. A high-level control voltage (first voltage) or a low-level control voltage (second voltage) is applied to the gain control terminal 11. The first voltage is used to turn on the NPN transistor 4a and turn off the PNP transistor 4b and is, for example, equal to the power supply voltage. The second voltage is used to turn off the NPN transistor 4a and turn on the PNP transistor 4b and is, for example, equal to zero volt.

Further, the resistance value of the fourth resistor 4f and that of the fifth resistor 4g are set to be different from each other. For example, the resistance value of the fourth resistor 4f is set to be larger than that of the fifth resistor 4g.

As a result, when the first voltage is applied to the gain control terminal 11, only the NPN transistor 4a is turned on and a first bias voltage is applied to the base of the amplifying transistor 3 by the sixth resistor 4h and the fourth resistor 4f.

On the other hand, when the second voltage is applied to the gain control terminal 11, only the PNP transistor 4b is turned on and a second bias voltage is applied to the base of the amplifying transistor 3 by the sixth resistor 4h and the fifth resistor 4g.

Since the first bias voltage is higher than the second bias voltage, the collector current of the amplifying transistor 3 becomes larger in the case where the first bias voltage is applied than in the case where the second bias voltage is applied, and the gain is also increased.

The level of the oscillation signal outputted from the amplifying transistor 3 can be therefore changed by the control voltage applied to the gain control terminal 11.

Obviously, a first switching diode and a second switching diode may be used in place of the NPN transistor 4a and the PNP transistor 4b in Figs. 2 and 3, and an ON operation and an OFF operation of the switching diodes may be performed so as to be opposite to each other.

As described above, the oscillating device of the invention has the oscillating unit for outputting an oscillation signal and the amplifying unit for amplifying the oscillation signal, and gain of the amplifying unit is switched in two levels. Consequently, the level of the oscillation signal outputted from the amplifying unit can be changed, so that the oscillating device can be used for a portable telephone of a different system. Therefore, models of the oscillating device can be standardized and the invention can contribute to reduction in size and price of a portable telephone.

In the oscillating device of the invention, the amplifying unit has the amplifying transistor for amplifying the oscillation signal and the bias voltage supplying circuit for supplying a bias voltage to the base of the amplifying transistor, the oscillation signal is supplied to the base of the amplifying transistor, a first bias voltage or a second bias voltage is supplied to the base of the amplifying transistor by the bias voltage supplying circuit, and the value of the first bias voltage and the value of the second bias voltage are set to be different from each other. Thus, the gain of the amplifying transistor can be easily changed.

In the oscillating device of the invention, the bias voltage supplying circuit has: first switching means and a first resistor which are connected to each other in series and are connected between a power source and the base of the amplifying transistor; second switching means and a second resistor which are connected to each other in series and are connected between the power source and the base of the amplifying transistor; and a third resistor connected between the base of the amplifying transistor and the ground, a resistance value of the first resistor and a resistance value of the second resistor are set to be different from each other, and either the first switching means is turned on and the second switching means is turned off, or the first switching means is turned off and the second switching means is turned on. Thus, the first and second bias voltages can be made different from each other.

In the oscillating device of the invention, an NPN transistor is used as the first switching means, a PNP transistor is used as the second switching means, and either a first voltage to turn on the NPN transistor and turn off the PNP transistor or a second voltage to turn off the NPN transistor and turn on the PNP transistor is applied to both the base of the NPN transistor and the base of the PNP transistor. The NPN and PNP transistors can be therefore easily turned on and off.

In the oscillating device of the invention, the bias voltage supplying circuit has: first switching means and a fourth resistor which are connected to each other in series and are connected between the base of the amplifying transistor and the ground; second switching means and a fifth resistor which are connected to each other in series and are connected between the base of the amplifying transistor and the ground; and a sixth resistor connected between the power source and the base of the amplifying transistor, a resistance value of the fourth resistor and a resistance value of the fifth resistor are set to be different from each other, and either the first switching means is turned on and the second switching means is turned off, or the first switching means is turned off and the second switching means is turned on. Thus, the first and second bias voltages can be made different from each other.

In the oscillating device of the invention, an NPN transistor is used as the first switching means, a PNP transistor is used as the second switching means, and either a first voltage to turn on the NPN transistor and turn off the PNP transistor or a second voltage to turn off the NPN transistor and turn on the PNP transistor is applied to both the base of the NPN transistor and the base of the PNP transistor. Consequently, the NPN transistor and the PNP transistor can be easily turned on and off.

In the oscillating device of the invention, the gain of the amplifying unit is changed by at least 3 dB to 4 dB. Consequently, the transmission power can be set within a predetermined range also against variations in gain of the power amplifier used for a portable telephone.

## Claims

1. An oscillating device comprising an oscillating unit for outputting an oscillation signal and an amplifying unit for amplifying the oscillation signal, wherein gain of the amplifying unit is switched in two levels.

2. The oscillating device according to claim 1, wherein the amplifying unit has an amplifying transistor for amplifying the oscillation signal and a bias voltage supplying circuit for supplying a bias voltage to the base of the amplifying transistor, the oscillation signal is supplied to the base of the amplifying transistor, a first bias voltage or a second bias voltage is supplied to the base of the amplifying transistor by the bias voltage supplying circuit, and the value of the first bias voltage and the value of the second bias voltage are set to be different from each other.

3. The oscillating device according to claim 2, wherein the bias voltage supplying circuit has: first switching means and a first resistor which are connected to each other in series and are connected between a power source and the base of the amplifying transistor; second switching means and a second resistor which are connected to each other in series and are connected between the power source and the base of the amplifying transistor; and a third resistor connected between the base of the amplifying transistor and the ground, a resistance value of the first resistor and a resistance value of the second resistor are set to be different from each other, and either the first switching means is turned on and the second switching means is turned off, or the first switching means is turned off and the second switching means is turned on.

4. The oscillating device according to claim 3, wherein an NPN transistor is used as the first switching means, a PNP transistor is used as the second switching means, the collector of the NPN transistor is connected to the power source and the emitter of the NPN transistor is connected to the base of the amplifying transistor via the first resistor, the emitter of the PNP transistor is connected to the power source and the collector of the PNP transistor is connected to the base of the amplifying transistor via the second resistor, and either a first voltage to turn on the NPN transistor and turn off the PNP transistor-or a second voltage to turn off the NPN transistor and turn on the PNP transistor is applied to both the base of the NPN transistor and the base of the PNP transistor.

5. The oscillating device according to claim 2, wherein the bias voltage supplying circuit has: first switching means and a fourth resistor which are connected to each other in series and are connected between the base of the amplifying transistor and the ground; second switching means and a fifth resistor which are connected to each other in series and are connected between the base of the amplifying transistor and the ground; and a sixth resistor connected between the power source and the base of the amplifying transistor, a resistance value of the fourth resistor and a resistance value of the fifth resistor are set to be different from each other, and either the first switching means is turned on and the second switching means is turned off, or the first switching means is turned off and the second switching means is turned on.

6. The oscillating device according to claim 5, wherein an NPN transistor is used as the first switching means, a PNP transistor is used as the second switching means, the emitter of the NPN transistor is connected to the ground and the collector of the NPN transistor is connected to the base of the amplifying transistor via the fourth resistor, the collector of the PNP transistor is connected to the ground and the emitter of the PNP transistor is connected to the base of the amplifying transistor via the fifth resistor, and either a first voltage to turn on the NPN transistor and turn off the PNP transistor or a second voltage to turn off the NPN transistor and turn on the PNP transistor is applied to both the base of the NPN transistor and the base of the PNP transistor.

7. The oscillating device according to any one of claims 1 to 6, wherein the gain of the amplifying unit is changed by at least 3 dB to 4 dB.
